# EUROPÄISCHE PATENTSCHRIFT

(11) **EP 2 243 906 B1**
(45) Veröffentlichungstag und Bekanntmachung des Hinweises auf die Patenterteilung: **17.09.2014**
(21) Anmeldenummer: 10158632.9
(22) Anmeldetag: 31.03.2010
(51) Int. Cl.: E05B 81/76

(54) **Kraftfahrzeugtürgriff mit Sensorelektronik**
Motor vehicle door handle with sensor electronics
Poignée de porte de véhicule automobile avec électronique de capteur

(30) Priorität: 22.04.2009 DE 102009002566
(43) Veröffentlichungstag der Anmeldung: 27.10.2010
(73) Patentinhaber: Huf Hülsbeck & Fürst GmbH & Co. KG, 42551 Velbert (DE)
(72) Erfinder: Van Gastel, Peter, 42699, Solingen (DE); Lindic, Iko, 45149, Essen (DE)
(74) Vertreter: Zenz

(56) Entgegenhaltungen:
- EP-A2- 1 164 240
- WO-A1-02/33203
- DE-A1-102005 017 451
- DE-A1-102007 012 111
- FR-A1- 2 825 743

## Beschreibung

Die Erfindung betrifft einen Türgriff eines Kraftfahrzeugs, wobei in dem Türgriff eine Sensorelektronik mit einer Sensorauswerte- und Steuerschaltung, die auf einer Leiterplatte angeordnet ist, und mit einer mit der Sensorauswerte- und Steuerschaltung verbundenen Sensorelektrode eines kapazitiven Sensors zum Erfassen einer Annäherung eines Objekts an den Türgriff angeordnet ist, wobei die Leiterplatte im Inneren des Türgriffs angeordnet ist.

Eine Sensorelektronik der eingangs genannten Art wird beispielsweise verwendet, um die Annäherung der Hand eines Bedieners (Fahrers) an einen Türaußengriff des Kraftfahrzeugs zu erfassen. Beim Erfassen der Annäherung der Hand des Bedieners initiiert eine in dem Kraftfahrzeug angeordnete Steuerelektronik eine Funkabfrage eines von dem Bediener mitgeführten ID-Gebers (elektronischen Schlüssels), d.h. eines Transponders oder Funksendeempfängers, den der Bediener bei sich (in einer Tasche der Kleidung oder in einer Aktentasche beispielsweise) trägt. Diese Funkabfrage wird zum Beispiel mit Hilfe des Aussendens eines Funksignals in einem Frequenzbereich von beispielsweise 125 kHz, d.h. einem LF-Frequenzbereich, ausgeführt, wobei zum Abstrahlen eine Spule verwendet wird, die beispielsweise innerhalb des Türgriffs angeordnet ist. Der ID-Geber empfängt, sofern er sich im Empfangsbereich der Sendespule befindet, das Funksignal, erkennt darin eine Aufforderung zur Identifizierung und sendet daraufhin seinerseits in einem höheren Frequenzbereich (beispielsweise im Megahertz-Frequenzbereich) ein Antwortsignal, welches einen den ID-Geber identifizierenden Code umfasst. Das Steuergerät des Kraftfahrzeugs empfängt diese Antwort, überprüft den Code und gibt daraufhin die Betätigung des Türschlosses mit Hilfe des vom Bediener ergriffenen Türgriffes frei. Der die Annäherung des Bedieners erfassende Sensor wird somit insbesondere deshalb eingesetzt, damit nicht ständig von der Sendespule ein Abfragesignal ausgesendet werden muss. Das Abfragesignal wird nur dann ausgesendet, wenn die Annäherung eines Körperteils des Bedieners erfasst worden ist.

Zum Erfassen der Annäherung eines Körperteils des Bedieners an den Türgriff wird üblicherweise ein kapazitiver Annäherungssensor verwendet. Ein solcher kapazitiver Annäherungssensor ist beispielsweise in der Druckschrift EP 1 339 025 A1 oder in der Druckschrift EP 1 235 190 beschrieben. Ferner ist ein Grundprinzip des Sensors beispielsweise in der Druckschrift US 5,730,165 A beschrieben.

Um die Empfindlichkeit eines eine Sensorelektrode aufweisenden kapazitiven Sensors zu verbessern bzw. um die Sensorreichweite zu vergrößern, wurde vorgeschlagen, zwischen der Sensorelektrode und der Kraftfahrzeugseitig dahinter befindlichen metallischen Massefläche (eine Massefläche kann auch in einer Schaltung innerhalb des Türgriffs vorhanden sein) eine abschirmende Metallfläche vorzusehen, wobei das Potential dieser abschirmenden Metallfläche mittels einer Spannungsverfolgerschaltung dem Potential der Sensorelektrode nachgeführt wird (ohne dass die beiden Elektroden unmittelbar miteinander gekoppelt sind). Eine derartige aktive Abschirmung ist beispielsweise in der Druckschrift EP 0 518 836 A1 oder in der Druckschrift EP 1 164 240 beschrieben.

Ausgehend von diesem Stand der Technik liegt der Erfindung die Aufgabe zugrunde, eine in einem Türgriff eines Kraftfahrzeugs angeordnete Sensorelektronik der eingangs genannten Art zu schaffen, bei der die Empfindlichkeit verbessert, die Störanfälligkeit verringert und ein kompakter Aufbau ermöglicht wird.

Diese Aufgabe wird erfindungsgemäß durch einen Türgriff eines Kraftfahrzeugs mit einer in dem Türgriff angeordneten Sensorelektronik mit den Merkmalen des Patentanspruchs 1 gelöst. Diese Sensorelektronik weist eine Sensorauswerte- und Steuerschaltung auf, die auf einer Leiterplatte angeordnet ist, die eine ein Massepotential führende Masse-Metallisierungsebene aufweist. Ferner umfasst die Sensorelektronik eine mit der Sensorauswerte- und Steuerschaltung verbundene Sensorelektrode eines kapazitiven Sensors zum Erfassen einer Annäherung eines Objekts an den Türgriff, und eine zwischen der Sensorelektrode und der Masse-Metallisierungsebene der Leiterplatte angeordnete Schirmelektrode und eine mit der Schirmelektrode gekoppelte Schirmelektrodenansteuerschaltung, die das Potential der Schirmelektrode dem Potential der Sensorelektrode nachführt. Unter einer Sensorauswerte- und Steuerschaltung soll hier jede Schaltungsanordnung verstanden werden, die einerseits Schaltungen zum Auswerten und Weiterleiten von Sensorausgangssignalen und andererseits Schaltungen zum Ansteuern von Sensoren und/oder anderen Elementen der Türelektronik umfasst. Die Leiterplatte ist im Inneren des Türgriffs angeordnet und die Bauelemente der Sensorauswerte- und Steuerschaltung sind auf einer Oberseite der Leiterplatte montiert. Die Leiterplatte weist wenigstens vier durch Isolatorschichten voneinander isolierte Metallisierungsebenen auf, wobei eine an der Oberseite angeordnete erste Metallisierungsebene Leitungsverbindungen zwischen den Bauelementen der Sensorauswerte- und Steuerschaltung umfasst, eine zweite Metallisierungsebene die Masse-Metallisierungsebene ist, eine dritte Metallisierungsebene die Schirmelektrode umfasst, und eine vierte Metallisierungsebene die Sensorelektrode umfasst, so dass die Anschlussleitungen der Bauelemente der Sensorauswerte- und Steuerschaltung auf der einen Seite der Masse-Metallisierungsebene und die Schirmelektrode sowie die Sensorelektrode auf der anderen Seite der Masse-Metallisierungsebene angeordnet sind. Eine solche Anordnung gestattet es, mit einer einzigen Leiterplattenstruktur einerseits eine geschirmte kapazitive Sensorelektrode zu schaffen und andererseits durch die Einkopplung der Schirmung zwischen der Sensorelektrode und der Schaltungsanordnung die Einwirkungen der in der Sensorauswerte- und Steuerschaltung fließenden Ströme oder anliegenden Spannungen auf die Sensorelektrode zu verringern. Insgesamt wird durch die Erfindung die elektromagnetisch verträgliche Funktion aller elektrischen Mittel der Sensorelektronik gewährleistet, so dass die Einhaltung von Gesetzen und Richtlinien bezüglich der elektromagnetischen Verträglichkeit (EMV) sichergestellt ist.

Vorteilhafte und zweckmäßige Ausgestaltungen und Weiterbildungen der Erfindung ergeben sich aus den entsprechenden Unteransprüchen.

Bei einer bevorzugten Ausgestaltung umfasst die Sensorauswerte- und Steuerschaltung eine Sendespule einer Schaltung zur Kommunikation mit einem transportablen ID-Geber, d.h. beispielsweise die oben genannte Sendespule, welche ein Aufwecksignal im LF-Frequenzbereich (beispielsweise 125 kHz) an den ID-Geber abstrahlt. Bei dieser Ausführungsform erhöht die erfindungsgemäße Anordnung, insbesondere das Einschieben der Masse-Metallisierungsebene, die EMV-Sicherheit der Spule.

Hinsichtlich einer kompakten Bauweise der Sensorelektronik ist in Weiterbildung der Erfindung vorgesehen, dass die Schirmelektrodenansteuerschaltung Bestandteil der Sensorauswerte- und Steuerschaltung ist. Zur weiteren Erhöhung der Kompaktheit ist es dann von Vorteil, wenn Spannungsversorgungsleitbahnen für die Sensorauswerte- und Steuerschaltung in der ersten Metallisierungsebene angeordnet sind.

Bei einer weiteren Ausgestaltung der erfindungsgemäßen Sensorelektronik ist zwischen der ersten Metallisierungsebene und der Masse-Metallisierungsebene wenigstens eine weitere Metallisierungsebene angeordnet, welche Spannungsversorgungsleitbahnen und/oder Leitungsverbindungen zwischen den Bauelementen der Sensorauswerte- und Steuerschaltung aufweist.

Besonders bevorzugt ist es, wenn die Leiterplatte eine Gesamtdicke zwischen 1 mm und 3 mm, vorzugsweise etwa 1,5 mm, aufweist. Hierbei kann zwischen der zweiten Metallisierungsebene und der dritten Metallisierungsebene eine Isolatorschicht mit einer Dicke von 0,3 bis 2 mm, vorzugsweise etwa 0,5 mm, angeordnet sein.

In bevorzugter Ausgestaltung der Erfindung überragt die Schirmelektrode die Sensorelektrode seitlich allseitig mindestens um 0,3 mm, vorzugsweise um etwa 0,3 bis 0,6 mm.

In weiterer Ausgestaltung der Erfindung ist vorgesehen, dass die Metallisierungsebenen jeweils von Leitschichten, vorzugsweise Kupferschichten, von 35 µm bis 70 µm gebildet sind.

Schließlich sieht die Erfindung in Weiterbildung vor, dass die Leiterplatte derart benachbart zu einer Außenwandung des Türgriffs angeordnet ist, dass die Sensorelektrode an der Außenwandung anliegt.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Weitere Einzelheiten, Merkmale und Vorteile des Gegenstandes der Erfindung ergeben sich aus der nachfolgenden Beschreibung im Zusammenhang mit der Zeichnung, in der beispielhaft ein bevorzugtes Ausführungsbeispiel der Erfindung dargestellt ist. In der Zeichnung zeigt:

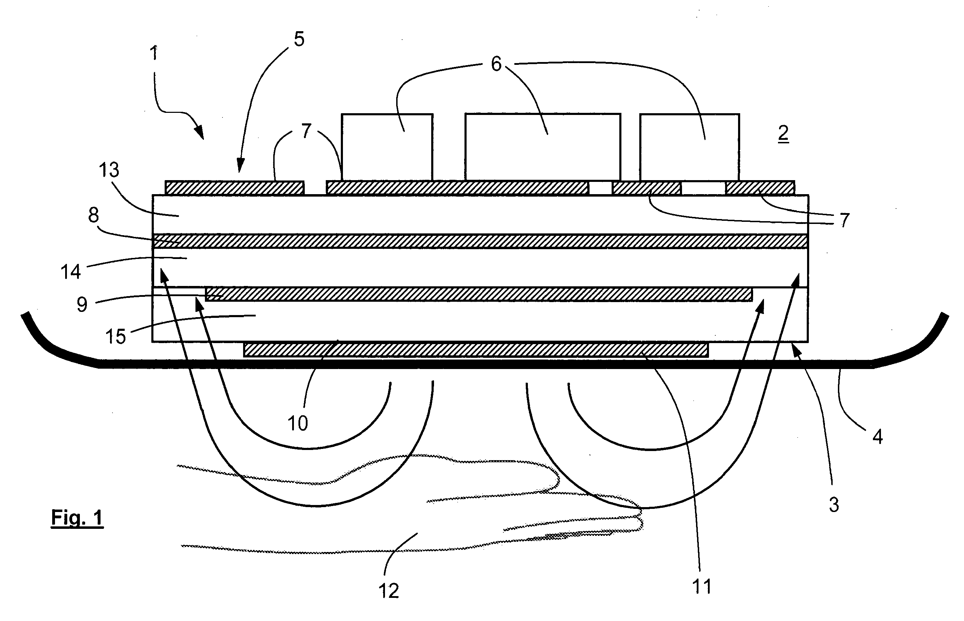

Figur 1 eine schematische Darstellung einer in einem Kraftfahrzeugtürgriff angeordneten erfindungsgemäßen Sensorelektronik.

Figur 1 zeigt eine schematische Schnittansicht einer erfindungsgemäßen Sensorelektronik, die in eine Leiterplatte 1 integriert ist. Die Leiterplatte 1 ist in einem Innenraum 2 eines Türgriffs eines Kraftfahrzeugs angeordnet und liegt mit einer Unterseite 3 an einer Außenwandung 4 des Türgriffs an. Auf einer Oberseite 5 der Leiterplatte 1 sind Bauelemente einer Sensorauswerte- und Steuerschaltung 6 befestigt.

Die Leiterplatte 1 weist eine an ihrer Oberseite 5 angeordnete erste Metallisierungsebene 7 auf. Die erste Metallisierungsebene 7 umfasst Leitungsverbindungen zwischen den Bauelementen der Sensorauswerte- und Steuerschaltung 6, einschließlich Spannungsversorgungsleitungen. Ferner weist die Leiterplatte 1 eine zweite Metallisierungsebene 8 auf, die eine Massefläche oder eine Masse-Metallisierungsebene ist, ein Massepotential führt und die Sensorauswerte- und Steuerschaltung 6 mit Masse versorgt.

Zusätzlich umfasst die Leiterplatte 1 eine dritte Metallisierungsebene 9 und eine vierte Metallisierungsebene 10. Die vierte Metallisierungsebene 10 weist wenigstens eine Sensorelektrode 11 eines kapazitiven Sensors auf, die beabstandet zu der Masse-Metallisierungsebene (zweite Metallisierungsebene 8) angeordnet ist. Die Sensorelektrode 11 dient zur Erfassung einer Annäherung eines Objektes an den Türgriff. In der Darstellung ist das Objekt eine Hand 12 eines Bedieners, die sich in dem von der Sensorelektrode 11 erzeugten elektrischen Feld befindet. Die Sensorelektrode 11 ist über eine Anschlussleitung (nicht gezeigt) mit der Sensorauswerte- und Steuerschaltung 6 verbunden.

Die Sensorauswerte- und Steuerschaltung 6, welche auch als Ansteuerelektronik bezeichnet wird, enthält unter anderem eine Auswerteelektronik oder Messschaltung zum Bestimmen der Kapazität der Sensorelektrode 11 gegenüber der Masse. Zwischen der Sensorelektrode 11 und der Masse-Metallisierungsebene (zweite Metallisierungsebene 8) ist eine bestimmte Kapazität messbar, die einerseits von Form und Anordnung der Sensorelektrode 11 gegenüber der Masse-Metallisierungsebene und andererseits sowohl von dem zwischen der Sensorelektrode 11 und der Masse-Metallisierungsebene angeordneten Material als auch von den sich in der Umgebung der Sensorelektrode 11 aufhaltenden Objekten abhängig ist. Wenn zwischen der Sensorelektrode 11 und der Masse-Metallisierungsebene eine Spannung angelegt wird, so bildet sich zwischen der Sensorelektrode 11 und der Masse-Metallisierungsebene ein elektrisches Feld aus, welches normalerweise dort, wo die Sensorelektrode 11 den geringsten Abstand von der Masse-Metallisierungsebene hat, seine höchste Dichte (höchste Feldstärke) annimmt. Das stärkste elektrische Feld würde sich direkt zwischen der Sensorelektrode 11 und der Masse-Metallisierungsebene ausbilden, und nur ein geringer Teil des elektrischen Feldes würde in die Umgebung hineinreichen. Dieses wiederum würde bedeuten, dass Änderungen der sich in der Nähe befindenden Objekte einen relativ geringen Einfluss auf das elektrische Feld und somit auf die zwischen Sensorelektrode 11 und Masse-Metallisierungsebene gemessene Kapazität haben würden. Um die Empfindlichkeit der Sensorelektronik zu erhöhen, wurde vorgeschlagen, zwischen der Sensorelektrode 11 und der Masse-Metallisierungsebene, d.h. zwischen der vierten Metallisierungsebene 10 und der zweiten Metallisierungsebene 8, eine Schirmelektrode anzuordnen, die in der dritten Metallisierungsebene 9 ausgebildet ist. Eine Schirmelektrodenansteuerschaltung sorgt dafür, dass das Potential der Schirmelektrode dem Potential der Sensorelektrode 11 nachgeführt wird, wobei aber die Sensorelektrode 11 nicht direkt mit der Schirmelektrode verbunden ist. Die Schirmelektrode mit entsprechender Schirmelektrodenansteuerschaltung bewirkt dann, dass sich kein starkes elektrisches Feld mehr zwischen der Sensorelektrode 11 und der Masse-Metallisierungsebene ausbildet, sondern sich das Feld primär außerhalb der Leiterplatte 1 (d.h. vor dem Türgriff) ausbreitet. Dies wiederum führt zu einer stärkeren Abhängigkeit der Feldstärke bzw. der Kapazität der gesamten Anordnung von den sich in dem Feld befindenden Objekten, das heißt zu einer höheren Empfindlichkeit des kapazitiven Sensors, der sich damit besser als Annäherungssensor eignet.

Um die Kapazität des kapazitiven Sensors zu messen, gibt es verschiedene Vorgehensweisen. Bei den meisten Verfahren wird eine sich ändernde Spannung zwischen der Sensorelektrode 11 und der Masse-Metallisierungsebene angelegt, was wiederum bedeutet, dass das Potential der Schirmelektrode ständig dem Potential der Sensorelektrode 11 nachgeführt werden muss. Die Vorgehensweisen beim Messen der Kapazität und beim Nachführen des Potentials sind aus dem Stand der Technik bekannt, beispielsweise aus den Druckschriften EP 0 518 836 A1, DE 196 81 725 B4 oder DE 10 2006 044 778 A1. Die Messprinzipien und die Technik des Nachführens des Potentials der Schirmelektrode 11 sollen hier deshalb nicht näher beschrieben werden.

Insgesamt weist die Struktur der Leiterplatte 1 somit vier Metallisierungsebenen 7, 8, 9 und 10 auf, die durch Isolatorschichten 13, 14 und 15 voneinander isoliert sind, wobei die Anschlussleitungen der Bauelemente der Sensorauswerte- und Steuerschaltung 6 auf der einen Seite der Masse-Metallisierungsebene und die Schirmelektrode sowie die Sensorelektrode 11 auf der anderen Seite der Masse-Metallisierungsebene angeordnet sind.

Die Dicken der in Figur 1 schematisch dargestellten Metallisierungsebenen 7, 8, 9, 10 und Isolatorschichten 13, 14, 15 sowie die Abstände der Metallisierungsebenen 7, 8, 9, 10 voneinander hängen einerseits von der Herstellungstechnologie und anderseits vom gewünschten Einsatzgebiet der Sensorelektronik ab. Beispielsweise sind die jeweiligen Abstände zwischen den Metallisierungsebenen 7, 8, 9, 10 bzw. die Dicken der Isolatorschichten 13, 14, 15 größer als die Dicken der Metallisierungsebenen 7, 8, 9, 10. So kann zum Beispiel die zwischen der Masse-Metallisierungsebene (zweite Metallisierungsebene 8) und der Schirmelektrode (dritte Metallisierungsebene 9) angeordnete Isolatorschicht 14 eine Dicke von 0,3 mm bis 2 mm aufweisen, wobei eine Dicke von etwa 0,5 mm bevorzugt ist. Im Übrigen können auch die anderen Isolatorschichten 13 und 15 eine mit der Dicke der Isolatorschicht 14 vergleichbare Dicke aufweisen. In diesem Zusammenhang ist es dann auch denkbar, dass die Metallisierungsebenen 7, 8, 9, 10 jeweils von Leitschichten von 35 µm bis 70 µm gebildet werden, wobei Kupferschichten als Leitschichten zu bevorzugen sind. Wie ferner in Figur 1 dargestellt ist, überragt die Schirmelektrode 11 die Sensorelektrode 8 seitlich allseitig um mindestens 0,3 mm. Denkbar ist aber auch ein Bereich von etwa 0,3 bis 0,6 mm, um den die Schirmelektrode 11 die Sensorelektrode 8 seitlich allseitig überragt.

Bei einer bevorzugten Ausgestaltung umfasst die Sensorauswerte- und Steuerschaltung 6 eine Sendespule einer Schaltung zur Kommunikation mit einem transportablen ID-Geber.

Denkbar ist in weiterer Ausgestaltung der dargestellten Ausführungsformen, dass Spannungsversorgungsleitbahnen für die Sensorauswerte- und Steuerschaltung 6 in der ersten Metallisierungsebene 7 angeordnet sind.

Zwischen der ersten Metallisierungsebene 7 und der Masse-Metallisierungsebene (d.h. der zweiten Metallisierungsebene 8) kann ferner optional wenigstens eine weitere Metallisierungsebene angeordnet sein, welche Spannungsversorgungsleitbahnen und/oder Leitungsverbindungen zwischen den Bauelementen der Sensorauswerte- und Steuerschaltung 6 aufweist.

Insgesamt wird durch die Erfindung eine Sensorelektronik bereitgestellt, die in einer Leiterplatte 1 mit einer Dicke zwischen 1 mm und 3 mm integriert ist, wobei eine Gesamtdicke von etwa 1,5 mm bevorzugt ist. Die Leiterplatte 1 kann dabei derart benachbart zu der Außenwandung 4 des Türgriffs angeordnet sein, dass die Sensorelektrode 8 an der Außenwandung 4 anliegt.

## Patentansprüche

1. Türgriff eines Kraftfahrzeugs, wobei in dem Türgriff eine Sensorelektronik mit
einer Sensorauswerte- und Steuerschaltung (6), die auf einer Leiterplatte (1) angeordnet ist, die eine ein Massepotential führende Masse-Metallisierungsebene aufweist,
einer mit der Sensorauswerte- und Steuerschaltung (6) verbundenen Sensorelektrode (11) eines kapazitiven Sensors zum Erfassen einer Annäherung eines Objekts (12) an den Türgriff und
einer zwischen der Sensorelektrode (11) und der Masse-Metallisierungsebene der Leiterplatte (1) angeordneten Schirmelektrode und einer mit der Schirmelektrode gekoppelten Schirmelektrodenansteuerschaltung, die das Potential der Schirmelektrode dem Potential der Sensorelektrode (11) nachführt, angeordnet ist,
wobei die Leiterplatte (1) im Inneren (2) des Türgriffs angeordnet ist und die Bauelemente der Sensorauswerte- und Steuerschaltung (6) auf einer Oberseite (5) der Leiterplatte (1) montiert sind,
wobei die Leiterplatte (1) wenigstens vier durch Isolatorschichten (13, 14, 15) voneinander isolierte Metallisierungsebenen (7, 8, 9, 10) aufweist, wobei
eine an der Oberseite (5) der Leiterplatte (1) angeordnete erste Metallisierungsebene (7) Leitungsverbindungen zwischen den Bauelementen der Sensorauswerte- und Steuerschaltung (6) umfasst,
eine zweite Metallisierungsebene (8) die Masse-Metallisierungsebene ist,
eine dritte Metallisierungsebene (9) die Schirmelektrode umfasst und
eine vierte Metallisierungsebene (10) die Sensorelektrode (11) umfasst,
so dass die Anschlussleitungen der Bauelemente der Sensorauswerte- und Steuerschaltung (6) auf der einen Seite der Masse-Metallisierungsebene und die Schirmelektrode sowie die Sensorelektrode (11) auf der anderen Seite der Masse-Metallisierungsebene angeordnet sind.

2. Türgriff nach Anspruch 1, **dadurch gekennzeichnet, dass** die Sensorauswerte- und Steuerschaltung (6) eine Sendespule einer Schaltung zur Kommunikation mit einem transportablen ID-Geber umfasst.

3. Türgriff nach Anspruch 1 oder 2, **dadurch gekennzeichnet, dass** die Schirmelektrodenansteuerschaltung Bestandteil der Sensorauswerte- und Steuerschaltung (6) ist.

4. Türgriff nach einem der Ansprüche 1 - 3, **dadurch gekennzeichnet, dass** Spannungsversorgungsleitbahnen für die Sensorauswerte- und Steuerschaltung (6) in der ersten Metallisierungsebene (7) angeordnet sind.

5. Türgriff nach einem der Ansprüche 1 - 4, **dadurch gekennzeichnet, dass** zwischen der ersten Metallisierungsebene (7) und der Masse-Metallisierungsebene wenigstens eine weitere Metallisierungsebene angeordnet ist, welche Spannungsversorgungsleitbahnen und/oder Leitungsverbindungen zwischen den Bauelementen der Sensorauswerte- und Steuerschaltung (6) aufweist.

6. Türgriff nach einem der Ansprüche 1 - 5, **dadurch gekennzeichnet, dass** die Leiterplatte (1) eine Gesamtdicke zwischen 1 mm und 3 mm, vorzugsweise etwa 1,5 mm, aufweist.

7. Türgriff nach Anspruch 6, **dadurch gekennzeichnet, dass** zwischen der zweiten Metallisierungsebene (8) und der dritten Metallisierungsebene (9) eine Isolatorschicht (14) mit einer Dicke von 0,3 bis 2 mm, vorzugsweise etwa 0,5 mm, angeordnet ist.

8. Türgriff nach einem der Ansprüche 1 - 7, **dadurch gekennzeichnet, dass** die Schirmelektrode die Sensorelektrode (11) seitlich allseitig um mindestens 0,3 mm, vorzugsweise um etwa 0,3 bis 0,6 mm, überragt.

9. Türgriff nach einem der Ansprüche 1 - 8, **dadurch gekennzeichnet, dass** die Metallisierungsebenen (7, 8, 9, 10) jeweils von Leitschichten, vorzugsweise Kupferschichten, von 35 µm bis 70 µm gebildet sind.

10. Türgriff nach einem der Ansprüche 1 - 9, **dadurch gekennzeichnet, dass** die Leiterplatte (1) derart benachbart zu einer Außenwandung (4) des Türgriffs angeordnet ist, dass die Sensorelektrode (11) an der Außenwandung (4) anliegt.

## Claims

1. A door handle of a motor vehicle, wherein a sensor electronics is arranged in the door handle, the sensor electronics comprising
a sensor evaluation and control circuit (6) arranged on a circuit board (1) that has a ground-metallization plane conducting a ground potential,
a sensor electrode (11) of a capacitive sensor for detecting an approach of an object (12) to the door handle, which sensor electrode is connected to the sensor evaluation and control circuit (6), and
a shielding electrode arranged between the sensor electrode (11) and the ground-metallization plane of the circuit board (1), and a shielding electrode control circuit that is coupled to the shielding electrode and tracks the potential of the shielding electrode with the potential of the sensor electrode (11),
wherein the circuit board (1) is on the arranged inside (2) of the door handle and the components of the sensor evaluation and control circuit (6) are mounted on the upper side (5) of the circuit board (1),
wherein the circuit board (1) has at least four metallization planes (7, 8, 8, 10) that are insulated from each other by insulating layers (13, 14, 15), wherein
a first metallization plane (7) arranged on the upper side (5) of the circuit board (1) comprises line connections between the components of the sensor evaluation and control circuit (6),
a second metallization plane (8) is a ground-metallization plane,
a third metallization plane (9) comprises the shielding electrode and
a fourth metallization plane (10) comprises the sensor electronics (11),
so that the connection lines of the components of the sensor evaluation and control circuit (6) are arranged on the one side of the ground-metallization plane, and the shielding electrode and the sensor electrode (11) are arranged on the other side of the ground-metallization plane.

2. The door handle according to claim 1, **characterized in that** the sensor evaluation and control circuit (6) comprises a transmitter coil of a circuit for communication with a transportable ID encoder.

3. The door handle according to claim 1 or claim 2, **characterized in that** the shielding electrode control circuit is part of the sensor evaluation and control circuit (6).

4. The door handle according to any one of the claims 1 to 3, **characterized in that** voltage supply leads for the sensor and control circuit (6) are arranged in the first metallization plane (7).

5. The door handle according to any one of the claims 1 to 4, **characterized in that** between the first metallization plane (7) and the ground-metallization plane at least one further metallization plane is arranged which has voltage supply leads and/or line connections between the components of the sensor evaluation and control circuit (6).

6. The door handle according to any one of the claims 1 to 5, **characterized in that** the circuit board (1) has a total thickness between 1 mm and 3 mm, preferably approximately 1.5 mm.

7. The door handle according to claim 6, **characterized in that** an insulating layer (14) having a thickness of 0.3 to 2 mm, preferably approximately 0.5 mm is arranged between the second metallization plane (8) and the third metallization plane (9).

8. The door handle according to any one of the claims 1 to 7, **characterized in that** the shielding electrode laterally protrudes beyond the sensor electrode (11) on all sides by at least 0.3 mm, preferably by approximately 0.3 to 0.6 mm.

9. The door handle according to any one of the claims 1 to 8, **characterized in that** the metallization planes (7, 8, 9, 10) are each formed by conductive layers, preferably copper layers, of 35 µm to 70 µm.

10. The door handle according to any one of the claims 1 to 9, **characterized in that** the circuit board (1) is arranged adjacent to an outer wall (4) of the door handle in such a manner that the sensor electrode (11) rests against the outer wall (4).

## Revendications

1. Poignée de porte d'un véhicule automobile dans laquelle se trouve un système électronique de capteur avec
un circuit d'exploitation de capteur et de commande (6) qui est monté sur une carte de circuits imprimés (1), qui comporte un niveau de métallisation de masse conducteur d'un potentiel de masse,
une électrode de capteur (11) reliée au circuit d'exploitation de capteur et de commande (6) d'un capteur capacitif pour saisir une approche d'un objet (12) à la poignée de porte et
une grille de protection montée entre l'électrode de capteur (11) et le niveau de métallisation de masse de la carte de circuits imprimés (1) et un circuit de commande de grille de protection couplé à la grille de protection qui ajuste le potentiel de la grille de protection au potentiel de l'électrode de capteur (11),
pour laquelle la carte de circuits imprimés (1) est logée à l'intérieur (2) de la poignée de porte et les composants du circuit d'exploitation de capteur et de commande (6) sont montés sur la face supérieure (5) de la carte de circuits imprimés (1),
pour laquelle la carte de circuits imprimés (1) comporte au moins quatre niveaux de métallisation (7, 8, 9, 10) isolés les uns des autres par des couches isolantes (13, 14, 15), pour laquelle
un premier niveau de métallisation (7) disposés sur la face supérieure (5) de la carte de ciruits imprimés (1) comprend des liaisons câblées entre les composants du circuit d'exploitation de capteur et de commande (6),
un deuxième niveau de métallisation (8) est le niveau de métallisation de masse,
un troisième niveau de métalllisation (9) comprend la grille de protection et
un quatrième niveau de métallisation (10) comprend l'électrode de capteur (11),
de sorte que les câbles de connexion des composants du circuit d'exploitation de capteur et de commande (6) sont disposés sur un côté du niveau de métallisation de masse et la grille de protection ainsi que l'électrode de capteur (11) sur l'autre côté du niveau de métallisation de masse.

2. Poignée de porte selon la revendication 1 **caractérisée en ce que** le circuit d'exploitation de capteur et de commande (6) comprend une bobine émettrice d'un cicuit pour communication avec un émetteur d'identification (ID) transportable.

3. Poignée de porte selon la revendication 1 ou 2 **caractérisée en ce que** le circuit de commande de la grille de protection est une partie constituante du circuit d'exploitation de capteur et de commande (6).

4. Poignée de porte selon une quelconque des revendications 1 - 3 **caractérisée en ce que** les voies d'alimentation en tension pour le circuit d'exploitation de capteur et de commande (6) sont disposées dans le premier niveau de métallisation (7).

5. Poignée de porte selon une quelconque des revendications 1 - 4 **caractérisée en ce qu'**entre le premier niveau de métallisation (7) et le niveau de métallisation de masse est disposé au moins un autre niveau de métallisation qui comporte des voies d'alimentation en tension et/ou des connexions câblées entre les composants du circuit d'exploitation de capteur et de commande (6).

6. Poignée de porte selon une quelconque des revendications 1 - 5 **caractérisée en ce que** la carte de circuits imprimés (1) comporte une épaisseur totale entre 1 mm et 3 mm, de préférence environ 1,5 mm.

7. Poignée de porte selon la revendication 6 **caractérisée en ce qu'** une couche isolante (14) d'une épaisseur de 0,3 à 2 mm, de préférence environ 0,5 mm est disposée entre le deuxième niveau de métallisation (8) et le troisième niveau de métallisation (9).

8. Poignée de porte selon une quelconque des revendications 1 - 7 **caractérisée en ce que** la grille de protection dépasse l'électrode de capteur (11) latéralement de tous côtés d'au moins 0, 3 mm, de préférence d'environ 0,3 à 0,6 mm.

9. Poignée de porte selon une quelconque des revendications 1 - 8 **caractérisée en ce que** les niveaux de métallisation (7, 8, 9, 10) sont à chaque fois formés de couches conductrices, de préférence de couches en cuivre, de 35 µm à 70 µm.

10. Poignée de porte selon une quelconque des revendications 1 - 9 **caractérisée en ce que** la carte de circuits imprimés (1) est disposée voisine d'une paroi extérieure (4) de la poignée de porte de telle manière que l'électrode de capteur (11) est appliquée à la paroi extérieure (4).
